## Europäisches Patentamt
## European Patent Office
## Office européen des brevets

(19)

(11) Numéro de publication: **0 213 019**
**B1**

(12) **FASCICULE DE BREVET EUROPEEN**

(45) Date de publication du fascicule du brevet:
**06.09.89**

(51) Int. Cl.⁴: **H 05 K 7/14, H 05 K 7/20**

(21) Numéro de dépôt: **86401656.3**

(22) Date de dépôt: **24.07.86**

(54) **Support de calculateur de turbomachine d'aviation.**

(30) Priorité: **14.08.85 FR 8512367**

(43) Date de publication de la demande:
**04.03.87 Bulletin 87/10**

(45) Mention de la délivrance du brevet:
**06.09.89 Bulletin 89/36**

(84) Etats contractants désignés:
**DE FR GB**

(56) Documents cités:
**EP-A- 0 111 437**
**FR-A- 2 344 201**
**GB-A- 1 521 464**
**US-A- 3 202 878**

**IBM TECHNICAL DISCLOSURE BULLETIN, vol. 24, no. 12, mai 1982, page 6487, New York, US; F. SCHLEGEL: "Plug connector for electronic components"**

(73) Titulaire: **SOCIETE NATIONALE D'ETUDE ET DE CONSTRUCTION DE MOTEURS D'AVIATION, "S.N.E.C.M.A.", 2 Boulevard Victor, F-75015 Paris (FR)**

(72) Inventeur: **Rambach, Daniel, 51 bis, avenue de Ségur, F-75007 Paris (FR)**

(74) Mandataire: **Moinat, François, S.N.E.C.M.A. Service des Brevets Boîte Postale 81, F-91003 Evry Cédex (FR)**

# Description

La présente invention concerne d'une façon générale les supports de dispositifs électroniques tels que par exemple des calculateurs ou des dispositifs de régulation électronique de turbomoteurs d'aviation.

Il est fréquent en matière de dispositifs électroniques d'utiliser des calculateurs intégrés dans des boîtes indépendantes qui viennent se loger dans des baies de calcul où les divers calculateurs sont reliés entre eux et à des divers équipements par l'intermédiaire de connecteurs disposés à l'arrière des boîtes et coopérant avec des connecteurs appariés de la baie de calcul. De tels dispositifs sont utilisés en matière d'électronique aérospatiale principalement pour les calculateurs ou les enregistreurs disposés à l'intérieur de la cellule de l'avion. Ainsi, le brevet FR 2 344 201 montre un chassis de ce genre utilisé pour le support d'une «boîte noire».

Ces dispositifs n'ont guère à résoudre que des problèmes de facilité «d'emboîtage» du calculateur dans sa baie de calcul, car les conditions d'utilisation telles que la température, les vibrations, le volume disponible ne sont pas très critiques.

Il en est tout autrement dans l'environnement des turboréacteurs d'aviation. Ceux-ci sont le plus souvent équipés d'une régulation électronique et une tendance actuelle est de monter ces calculateurs sur la paroi même du turboréacteur de façon à réduire l'importance et la longueur des liaisons électriques.

Une autre tendance actuelle est de réaliser aussi souvent que possible des dispositifs modulaires pouvant être montés et démontés séparément afin de diminuer les temps d'intervention dans l'entretien des moteurs. Pour faciliter la pose et la dépose d'un calculateur, on essaie de regrouper l'ensemble des cablages sur un nombre restreint de connecteurs auxquels aboutissent les cablages regroupés en faisceaux souvent très volumineux. Des connecteurs fixes sont placés sur le calculateur électronique tandis que les connecteurs mobiles appariés sont solidaires des faisceaux et amovibles manuellement pour permettre pose et dépose du calculateur. Se pose dès lors, le problème de la tenue mécanique des cablages et de leur disposition. En effet, plus les liaisons électriques sont rassemblées en gros faisceaux, plus ceux-ci sont difficiles à manipuler et difficiles à réparer. En outre, on ne peut, par manque de place, disposer les connecteurs fixes sur la paroi du calculateur qui fait face à celle du turboréacteur et les connecteurs mobiles sur une paroi correspondante du support, disposition qui serait intéressante pour que l'enfichage des connecteurs se fasse dans le mouvement rectiligne d'approche du calculateur vers son support, comme cela se fait dans une baie électronique traditionnelle. En effet, dans le cas des turboréacteurs d'aviation, l'espace radial disponible autour du turboréacteur est de faible épaisseur et une disposition arrière des connecteurs et des faisceaux de cables exigerait trop de place radialement, ce qui serait inacceptable.

Un autre problème à résoudre est celui de la résistance des composants électroniques aux vibrations qui sont importantes et durables dans l'environnement proche d'un turboréacteur, ce qui nécessite de disposer le calculateur sur un support comportant des moyens d'amortissement.

Enfin, la proximité du moteur fait subir au calculateur des flux de chaleur importants qu'il convient de diminuer le plus possible pour rester dans les tolérances d'utilisation des composants.

La présente invention a pour but de réaliser un support pour calculateur de turboréacteur d'aviation qui permette de le disposer sur la paroi du turboréacteur.

Elle a donc pour but de fournir un support qui permette de disposer le calculateur dans un espace d'épaisseur restreinte tout en gardant les avantages d'une liaison électrique entre calculateur et équipements par connecteurs multibroches mais en évitant les inconvénients des gros faisceaux de cables liés aux connecteurs multibroches traditionnels.

L'invention a également pour but de permettre l'utilisation de fils de petit diamètre, donc moins lourds, tout en ayant une meilleure fiabilité en exploitation en évitant des manipulations fréquentes et dangereuses pour ces fils.

Elle a aussi pour but de permettre la pose ou la dépose du calculateur sans manipuler le cablage extérieur et dans le cas de calculateurs doubles assurant une redondance de fonctions, de permettre la pose ou la dépose d'une seule des chaînes de calcul indépendamment de l'autre chaîne.

Un autre but de l'invention est de réaliser un support de calculateur de turboréacteur qui assure le refroidissement du calculateur et supprime ou atténue fortement les vibrations dues à la proximité du moteur.

L'invention a donc pour objet un support pour calculateur électronique notamment pour régulateur de turboréacteur d'aviation, le calculateur comprenant sur une face latérale au moins un connecteur multibroche destiné à être mis en contact avec un connecteur correspondant du support, ce dernier comportant d'une part une face arrière et/ou deux faces supérieure et inférieure comprenant des premiers moyens d'accrochage coopérant avec des seconds moyens d'accrochage portés par les faces correspondantes du calculateur, et d'autre part une face latérale portant le connecteur correspondant.

Selon l'invention telle qu'elle est revendiquée, l'accouplement des connecteurs s'effectue perpendiculairement à ladite face latérale et les premiers et les seconds moyens d'accrochage sont agencés pour coopérer entre eux d'abord dans un premier mouvement d'introduction du calculateur de l'avant vers l'arrière jusqu'à la mise en concordance des axes des deux connecteurs en correspondance, puis dans un second mouvement orthogonal au premier, jusqu'à l'emboîtement des connecteurs en correspondance.

Selon l'invention, le connecteur lié au support est porté par un boîtier annexe de raccordement fixé de façon amovible à la face latérale du support, le boîtier annexe comportant un circuit de répartition assurant la liaison du connecteur avec les faisceaux de cables provenant des divers équipements du turboréacteur associés au calculateur et les douilles du connecteur porté par le boîtier annexe co-agissent avec les broches du connecteur correspondant du calculateur au travers d'une lumière de la face latérale du support.

Selon une caractéristique de l'invention, lorsqu'elle est appliquée à un calculateur double redondant, le calculateur étant formé de deux lignes de calcul distinctes disposées dans deux boîtes séparées comportant chacune au moins un connecteur, les deux boîtes peuvent être superposées à l'intérieur du support et portent chacune des seconds moyens d'accrochage coopérant avec les premiers moyens d'accrochage portés par le support, les connecteurs de chaque ligne de calcul coopérant alors avec les connecteurs correspondants, portés par le boîtier annexe de raccordement.

Dans ce cas, un circuit de répartition du boîtier annexe peut assurer les liaisons des deux calculateurs entre eux et de chacun des calculateurs avec les équipements du turboréacteur qui lui sont associés.

Selon un mode de réalisation du boîtier annexe, le circuit de répartition est constitué par une plaque de circuit imprimé supportant d'une part, le/les connecteur(s) assurant la liaison avec le/les calculateur(s) et d'autre part des broches de raccordement liées aux faisceaux de cables provenant du turboréacteur, le circuit de répartition assurant la liaison électrique entre le/les connecteur(s) multibroche(s) et les dites broches de raccordement.

Dans une variante d'exécution destinée à une utilisation dans des limites réduites d'encombrement, le boîtier annexe de raccordement pourra être disposé séparément du support, ce dernier comportant un connecteur fixe relié au connecteur du boîtier annexe par un faisceau de cables intermédiaire.

Selon une autre caractéristique de l'invention, la face arrière du support est traversée par une canalisation interne reliée à un circuit de distribution de fluide frais sous pression, carburant ou air, la circulation de ce fluide à l'intérieur de la face arrière du support assurant le refroidissement de celui ci.

D'autres particularités de l'invention et notamment des modes détaillés de réalisation des moyens d'accrochage du calculateur sur son support seront explicités dans les compléments de description qui vont suivre accompagnés de planches de figures montrant de façon non limitative des modes de réalisation et des variantes d'exécution de l'invention.

Parmi ces dessins,

Fig. 1 montre un exemple de disposition d'un calculateur et de son support selon l'invention sur la paroi d'un turboréacteur.

Fig. 2 montre en perspective le calculateur et son support avec son boîtier annexe de raccordement ouvert, ainsi qu'une première variante de réalisation des moyens d'accrochage du calculateur.

Fig. 3 montre une application de l'invention à un double calculateur redondant, avec la même variante de réalisation des moyens d'accrochage du calculateur.

Fig. 4 est une vue de côté du support montrant le boîtier annexe de raccordement, couvercle enlevé, et la fig. 4a montre un détail de la fig. 4.

Fig. 5 (5a, 5b) montre en perspective une deuxième variante de réalisation des moyens d'accrochage du calculateur.

Fig. 6, 7 et 8 en montrent d'autres variantes.

Fig. 9 montre le cas où pour des raisons d'encombrement limité, le boîtier annexe de raccordement est disposé sur le turboréacteur séparément du support.

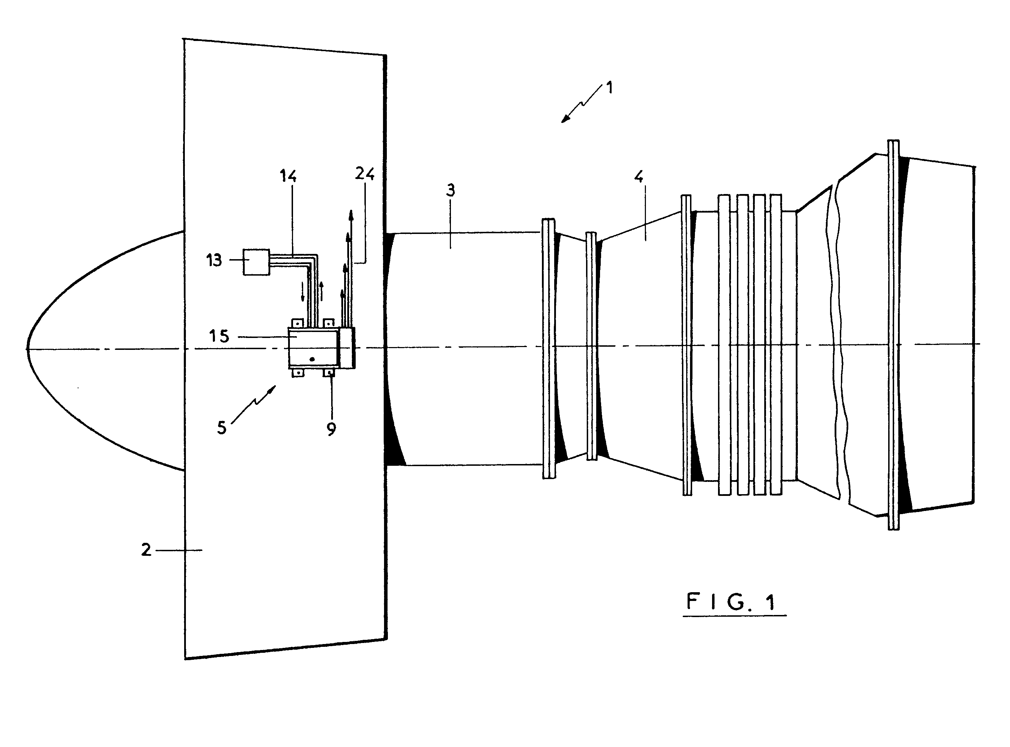

En regard de la fig. 1, où a été schématisé un turboréacteur d'aviation 1, on voit que celui-ci comporte une soufflante 2, un compresseur 3, une zone de combustion 4 et une turbine. Le support 5 selon l'invention est fixé sur la paroi externe de la soufflante 2. Bien sûr il est évident que si le turboréacteur n'est pas à double flux comme celui représenté sur l'exemple de la fig. 1, on disposera le support selon l'invention sur la paroi externe du compresseur, de préférence du compresseur basse pression qui représente une des zones les moins chaudes de la turbomachine.

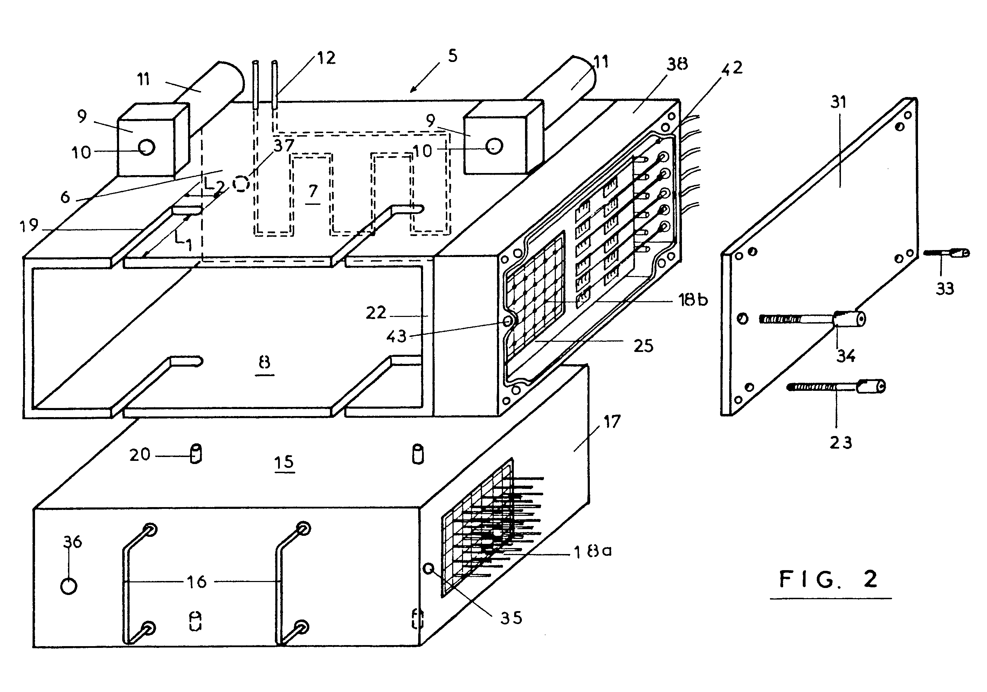

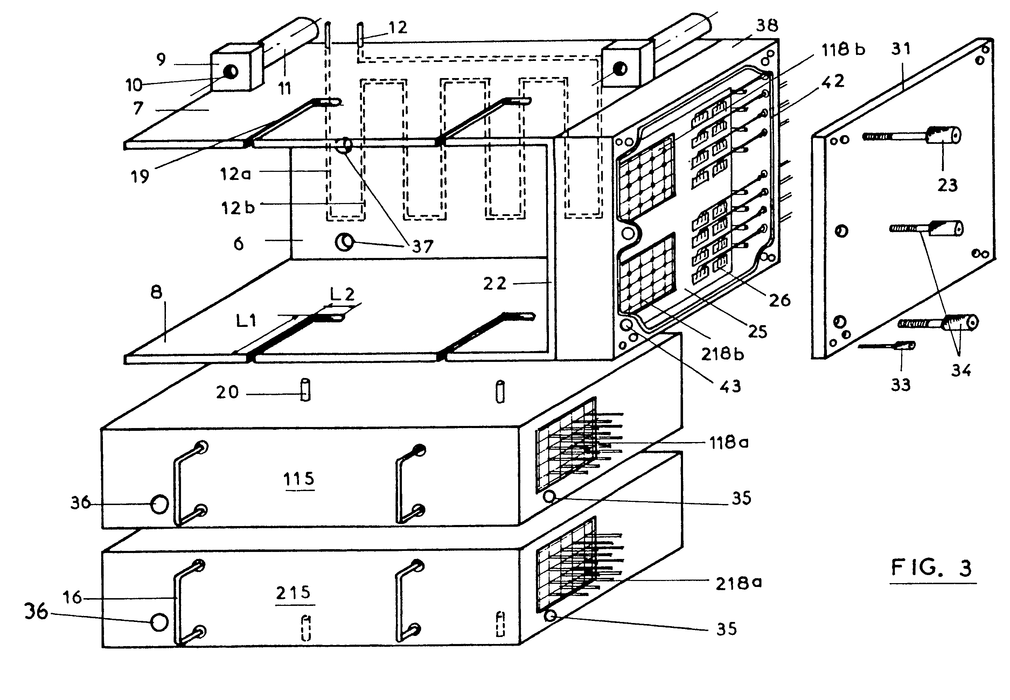

Le support 5 (fig. 2 et 3) comprend une face arrière 6 et des faces supérieure 7 et inférieure 8. Les faces 7 et 8 comportent des oreilles 9 percées d'alésages 10 permettant de les fixer au moyen de vis non représentées et de tampons amortisseurs de vibrations 11 sur la paroi du moteur. La face arrière 6 comporte dans son épaisseur une canalisation interne 12 présentant des parties parallèles entre elles 12a, 12b, etc. de telle sorte que la canalisation parcourt la totalité de la surface de la face arrière 6.

La canalisation 12 est reliée à la sortie d'une pompe 13 (figure 1) par un circuit 14 de distribution de carburant sous pression de façon à ce que le carburant utilisé comme fluide froid serve de réfrigérant au support et donc au calculateur qui sera porté par le support. Selon une variante, la canalisation 12 pourra être reliée à un circuit de distribution d'air frais prélevé sur les premiers étages du compresseur du turboréacteur, afin que l'air frais serve de réfrigérant.

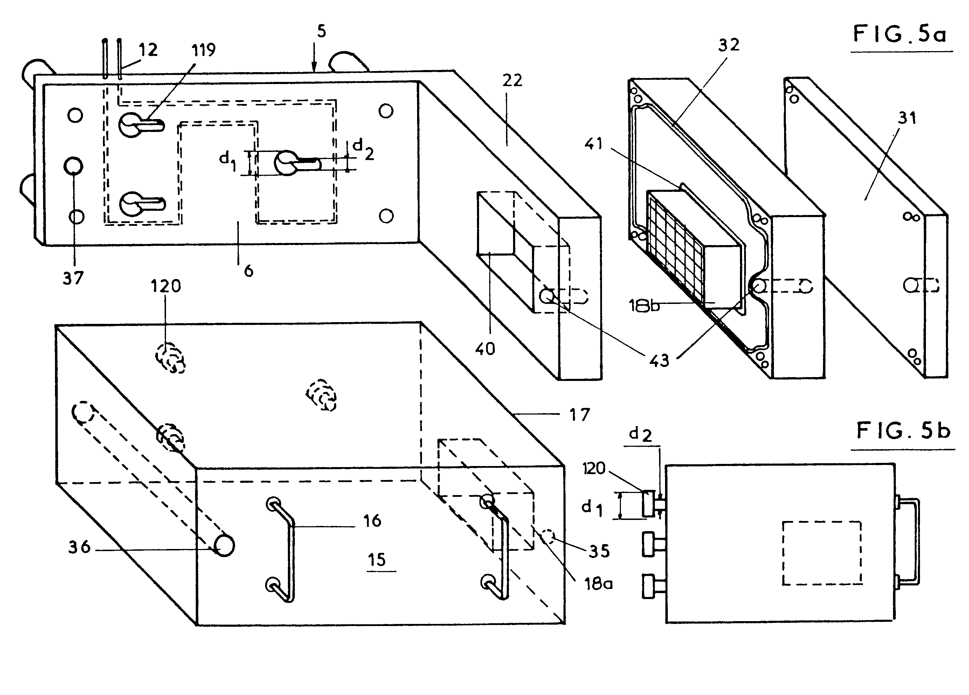

Le calculateur est contenu dans une boîte 15 munie sur sa face avant d'organes de préhension 16 et sur l'une 17 de ses faces latérales d'un connecteur 18a relié au circuit de calcul et destiné à mettre en liaison électrique celui-ci avec un connecteur correspondant 18b porté par le support. Les connecteurs sont disposés latéralement afin que le volume qu'ils occupent soit disposé dans le même espace radial que le calculateur de façon à ce que ce dernier monté sur son support, soit contenu dans une limite d'encombrement radial la plus faible possible. Les connecteurs 18a, 18b sont mis en liaison au travers d'une lumière 40 pratiquée dans la paroi latérale 22 du support 5 (voir fig. 5a, 6, 7, 8). La disposition latérale du connecteur nécessite donc pour la mise en place du calculateur dans son support un mouvement latéral de gauche à droite dans les exemples représentés. Afin de garantir la sécurité des broches du connecteur 18a pendant les opérations de pose/dépose successives du calculateur lors des périodes d'entretien, on réalise selon l'invention des moyens d'accrochage du calculateur sur son support qui imposent nécessairement lors de la pose, un premier mouvement d'approche du calculateur de l'avant vers l'arrière afin de mettre en concordance les axes des deux connecteurs 18a, 18b cette concordance devant être réalisée lorsque la face arrière du calculateur est en appui contre la face arrière du support, puis dans une seconde phase un mouvement latéral, ici de gauche à droite jusqu'à l'emboîtement des deux connecteurs. Ce double mouvement permet d'assurer simultanément un bon refroidissement du calculateur par contact de sa face arrière avec la paroi refroidie 6 du support et la liaison électrique du calculateur avec les équipements auxquels il est associé.

Pour réaliser ce double mouvement d'accrochage, le dispositif selon l'invention comporte dans une première variante (telle que montrée aux fig. 2 et 3) des premiers moyens portés par les faces supérieure et inférieure du support constitués par des doubles fentes 19 en équerre en forme de baïonnettes tandis que le calculateur comporte sur ses faces supérieure et inférieure des tétons 20 constituant les seconds moyens d'accrochage. La double fente 19 est constituée d'une première partie de longueur L1 orthogonale au fond 6 du support et d'une seconde partie de longueur L2 parallèle au fond, la position des tétons 20 sur le calculateur et les longueurs L1 et L2 étant calculées de telle sorte que la longueur L1 corresponde à la position de contact entre le calculateur et le fond et que la longueur L2 soit au moins égale à la longueur des broches du connecteur 18a.

Dans une deuxième variante d'exécution (fig. 5), les moyens d'accrochage sont constitués par des ouvertures 119 en forme de boutonnières pratiquées sur le fond 6 du support et comprenant un orifice rond de diamètre d1 prolongé d'un trou oblong de largeur d2 inférieure à d1 orienté dans la direction d'enfichage du connecteur et coopérant avec des pions 120 du fond du calculateur, pions de diamètre d2 possédant à leur extrémité libre des collets élargis au diamètre d1, la longueur de la portée cylindrique de diamètre d2 étant égale à l'épaisseur du fond du support.

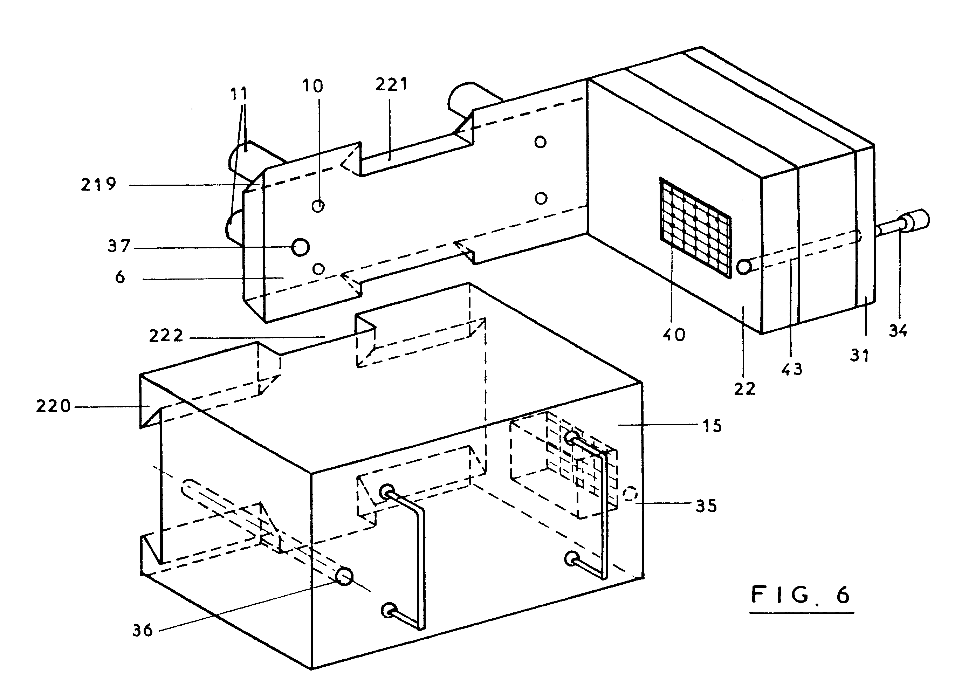

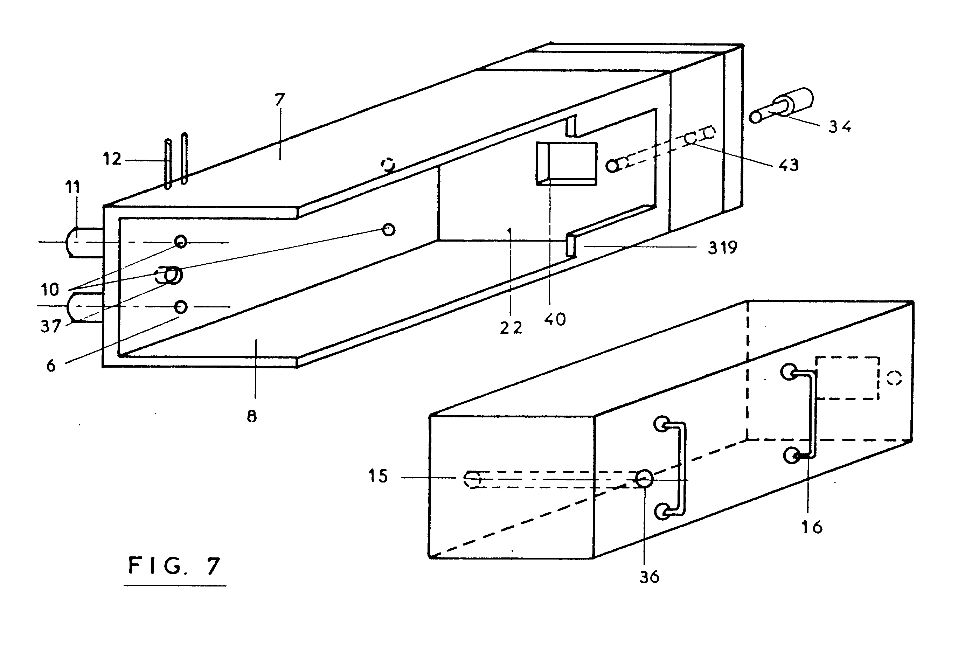

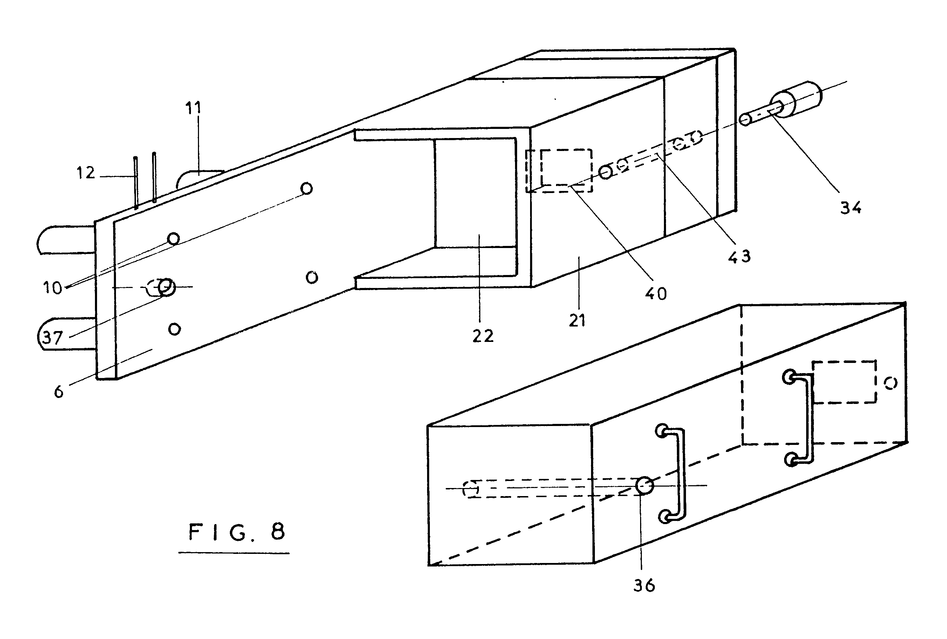

Dans une troisième variante (figure 6), les moyens d'accrochage sont réalisés sous forme d'un emboîtage à queue d'aronde, le fond 6 du support comportant une glissière 219 coopérant avec une rainure 220 du fond du calculateur, les moyens 219, 220 comportant chacun au moins une encoche d'entrée respectivement 221, 222 décalées entre elles pour permettre l'introduction du calculateur sur le support par un double mouvement avant-arrière puis latéral. Dans la variante de la fig. 7, on pourra prévoir de réaliser sur les bords avant des faces supérieure et inférieure du support une glissière 319 permettant le guidage du calculateur, tandis que dans la variante de la fig. 8, le support pourra comporter un panneau avant 21 sur une partie de sa largeur délimitant une niche dans laquelle vient se disposer le calculateur.

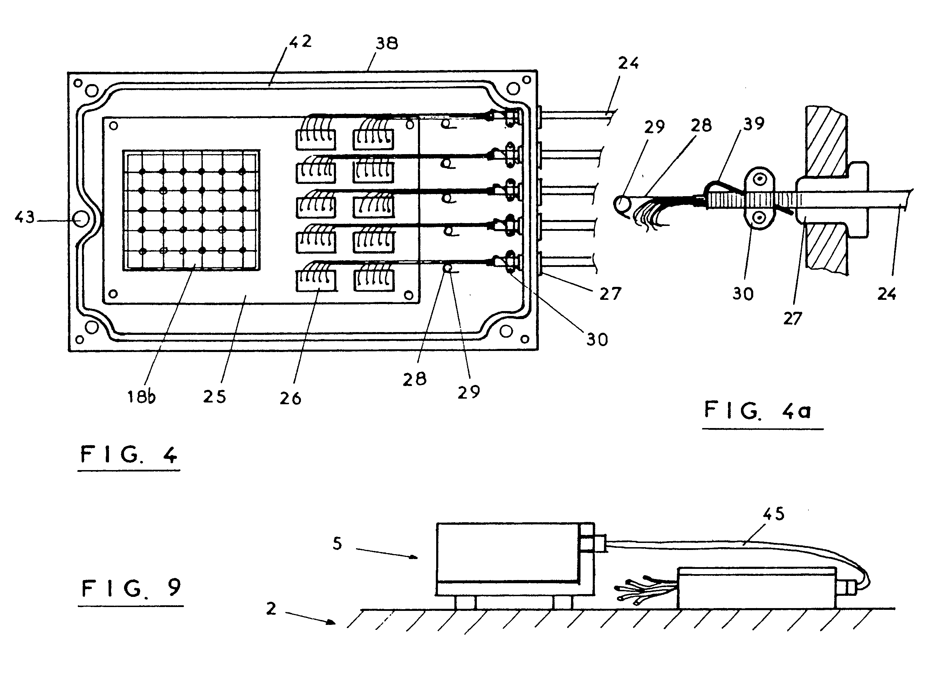

Sur la face latérale 22 du support (figure 2) est fixé de façon amovible par tout moyen connu (par exemple par des vis 23) un boîtier de raccordement annexe 38 assurant la liaison électrique entre le connecteur 18b et les cables 24 provenant des divers équipements ou composants du moteur. Le boîtier 38 comporte (fig. 4 et 4a) un circuit de répartition électrique constitué par une plaque de circuit imprimé 25 sur laquelle sont soudées les connexions arrières du connecteur multibroche 18b. Les conducteurs du circuit imprimé 25 assurent la répartition des divers circuits vers des broches de raccordement 26, chaque broche 26 étant reliée à un des cables 24 provenant de l'extérieur du boîtier au travers d'un joint étanche 27. Le nombre et la taille des cables sont optimisés de façon à rassembler les fils en petits torons en fonction de leur destination et à éviter d'une part qu'ils soient en trop grand nombre, donc trop lourds et trop chers, et d'autre part qu'ils soient en trop petit nombre et nécessitent des faisceaux de fils trop rigides et trop complexes.

En sortie du boîtier, ces cables 24 sont orientés de façon à tenir la place la plus réduite possible.

Les cables 24 comportent à l'intérieur de chaque toron un fil métallique 28 (figures 4, et 4a) résistant mais souple et arrêté mécaniquement par exemple par une vis 29 d'amarrage à l'intérieur du boîtier destinée à supporter toute traction éventuelle sur le cable. Grâce à ce fil métallique les fils électriques utilisés dans les torons peuvent être de petit diamètre donc moins lourds tout en ayant une meilleure fiabilité en exploitation.

Les blindages basse fréquence associés aux fils sont connectés aux broches de raccordement 26 du boîtier pour assurer leur continuité électrique.

Les blindages haute fréquence 39 associés aux cables sont reliés aux colliers de serrage 30 qui maintiennent les cables à leur entrée à l'intérieur du boîtier et assurent leur mise à la masse métallique du boîtier.

Le boîtier annexe (fig. 2 et 3) est fermé par un couvercle 31 muni de vis de fixation 33. Le boîtier annexe 38 peut être retiré, fermé, de son support en retirant les vis 23, qui, alors, doivent déboucher à l'extérieur du couvercle 31.

L'étanchéité est réalisée entre boîtier annexe et support par des joints 32 et 41 (fig. 5a) et entre le boîtier annexe et son couvercle par un joint 42 (fig. 4).

Un dispositif complémentaire permet de faciliter l'emboîtage des connecteurs 18a et 18b. Ce dispositif peut être constitué simplement par un système vis 34 - trou taraudé 35 du calculateur, la vis 34 coopérant avec le trou taraudé 35 au travers des alésages 43 du boîtier annexe, du support et du couvercle. Ce dispositif peut également être remplacé par tout autre dispositif connu par exemple à poignée à levier permettant de démultiplier la force nécessaire à l'enfichage du connecteur.

En outre peut être prévu un moyen de verrouillage du calculateur en position active sur le support, tel qu'une vis traversant un alésage 36 du calculateur et coopérant avec un taraudage 37 du support.

Dans le cas (figure 3) où on utilise un double calculateur redondant comprenant deux lignes de calcul en parallèle, chaque ligne de calcul étant disposée dans une boîte individuelle (resp. 115, 215) et comprenant un connecteur (resp. 118a, 218a) le circuit de répartition 25 assure les liaisons entre les deux calculateurs au moyen des connecteurs correspondants 118b 218b qu'il porte, ainsi qu'entre chaque calculateur et les équipements qui lui sont associés, au moyen des broches de raccordement 26.

Dans le cas où l'espace disponible est très réduit autour du turboréacteur, on peut séparer support et boîtier annexe de raccordement, auquel cas les connecteurs 18a et 18b seront reliés entre eux par un faisceau intermédiaire 45 comportant un connecteur à chaque extrémité (fig. 9). L'avantage d'un tel support est de permettre la disposition d'un calculateur modulaire sur la paroi d'un turboréacteur en facilitant les opérations d'entretien, de pose-dépose du ou des calculateurs tout en ne nécessitant pas de gros faisceaux de cables lourds et encombrants.

Un autre avantage est de permettre des interventions dans le boîtier de raccordement annexe pour effectuer des opérations électriques particulières telles que mesure, pontage, coupure, modification ou réparation d'un toron sans avoir à manipuler les autres torons.

Ainsi on améliore la fiabilité des liaisons électriques entre calculateur et équipements.

**Revendications**

1. Support pour calculateur électronique, notamment pour turboréacteur d'aviation, le calculateur comprenant sur une face latérale au moins un connecteur multibroche destiné à être mis en contact avec au moins un connecteur correspondant du support, ce dernier comportant une face arrière et/ou deux faces supérieure et inférieure comprenant des premiers moyens d'accrochage (19, 119, 219) coopérant avec des seconds moyens d'accrochage (20, 120, 220) portés par les faces correspondantes du calculateur, caractérisé en ce que le support comporte en outre une face latérale portant le connecteur du support, en ce que l'accouplement des connecteurs s'effectue perpendiculairement à ladite face latérale, en ce que les premiers et les seconds moyens d'accrochage sont agencés pour coopérer d'abord dans un premier mouvement d'introduction du calculateur de l'avant vers l'arrière jusqu'à la mise en concordance des axes des connecteurs en correspondance (18a, 18b, 118a, 218a, 118b, 218b) puis dans un second mouvement orthogonal au premier, jusqu'à l'emboîtement des connecteurs en correspondance, et en ce que le connecteur (18b, 118b, 218b) lié au support est porté par un boîtier annexe de raccordement (38) fixé de façon amovible à la face latérale (22) du support.

2. Support selon la revendication 1 caractérisé en ce que le boîtier annexe comporte un circuit de répartition (25) assurant la liaison du connecteur avec les faisceaux de cables (24) provenant des divers équipements du turboréacteur associés au calculateur et en ce que les douilles du connecteur porté par le boîtier annexe coagissent avec les broches du connecteur correspondant du calculateur au travers d'une lumière (40) de la face latérale du support.

3. Support selon l'une quelconque des revendications 1 et 2 pour calculateur double redondant, le calculateur étant formé de deux lignes de calcul (115, 215) distinctes disposées dans deux boîtes séparées comportant chacune au moins un connecteur (118a, 218a), caractérisé en ce que les deux boîtes sont superposées à l'intérieur du support et portent chacune des seconds moyens d'accrochage (20) coopérant avec les premiers moyens d'accrochage (19) portés par le support, en ce que les connecteurs (118a, 218a) de chaque ligne de calcul coopèrent avec les connecteurs (118b, 218b) correspondants du support et en ce que le circuit de répartition (25) du boîtier annexe assure les liaisons des deux calculateurs (115, 215) entre eux et de chacun des calculateurs avec les équipements du turboréacteur qui lui sont associés.

4. Support selon l'une quelconque des revendications 2 ou 3, caractérisé en ce que le circuit de répartition est constitué par une plaque de circuit imprimé (25) supportant d'une part le/les connecteur(s) (18b, 118b, 218b) assurant la liaison avec le/les calculateur(s) et d'autre part des broches de raccordement (26) liées aux faisceaux de cables provenant du turboréacteur, le circuit de répartition assurant la liaison électrique entre le/les connecteur(s) multibroche(s) et lesdites broches de raccordement.

5. Support selon l'une quelconque des revendications 1 à 4 caractérisé en ce que les premiers moyens d'accrochage sont constitués par des fentes en forme de baïonnette (19) en deux parties orthogonales reliées entre elles pratiquées dans les faces supérieure et inférieure (7, 8) du support et coopérant avec les seconds moyens d'accrochage constitués par des tétons (20) portés par les faces supérieure et inférieure du calculateur.

6. Support selon l'une quelconque des revendications 1 à 4 caractérisé en ce que les premiers moyens d'accrochage sont constitués par des ouvertures (119) pratiquées sur la face arrière (6) du support en forme de boutonnière orientées perpendiculairement à la face latérale dudit support et coopérant avec les seconds moyens d'accrochage constitués par des pions (120) à collet élargi portés par la face arrière du calculateur.

7. Support selon l'une quelconque des revendications 1 à 4 caractérisé en ce que les premiers moyens d'accrochage sont constitués par une glissière (219) portée par la face arrière (6) du support comprenant au moins une encoche (221) coopérant avec une rainure en queue d'aronde (220) possédant au moins une encoche d'entrée (222) correspondante décalée par rapport à celle de la rainure pour permettre la mise en place du calculateur par deux mouvements successifs de directions orthogonales entre elles.

8. Support selon l'une quelconque des revendications 1 à 7 caractérisé en ce qu'il est monté sur la paroi du turboréacteur au moyen de dispositifs (11) amortisseurs de vibration.

9. Support selon l'une quelconque des revendications 1 à 8 caractérisé en ce que sa face arrière (6) est traversée par une canalisation interne (12) reliée à un circuit de distribution (14) de carburant sous pression alimenté par une pompe (13), la circulation du carburant à l'intérieur de la face arrière du support assurant par contact du support et du calculateur le refroidissement de celui-ci.

10. Support selon l'une quelconque des revendications 1 à 8 caractérisé en ce que sa face arrière (6) est traversée par une canalisation interne (12) reliée à un circuit de distribution d'air frais prélevé sur les premiers étages du compresseur du turboréacteur, la circulation d'air à l'intérieur de la face arrière du support assurant par contact du support et du calculateur le refroidissement de celui-ci.

**Patentansprüche**

1. Halterung für einen elektronischen Rechner, insbesondere für den Rechner eines Turbostrahltriebwerks, der an einer seiner Seitenflächen wenigstens ein vielpoliges Verbinderteil aufweist, das mit wenigstens einem korrespondierenden Verbinderteil der Halterung in Kontakt zu bringen ist, wobei die Halterung an ihrer Rückseite und/oder an ihrer Ober- und Unterseite erste Verhakungsmittel (19, 119, 219) aufweist, die mit zweiten Verhakungsmitteln (20, 120, 220) zusammenwirken, die an den korrespondierenden Seiten des Rechners angeordnet sind, dadurch gekennzeichnet, daß das Verbinderteil der Halterung an einer Seitenfläche der Halterung angeordnet ist, daß das Zusammenfügen der Verbinderteile senkrecht zu dieser Seitenfläche erfolgt, daß die ersten und die zweiten Verhakungsmittel so angeordnet sind, daß sie zunächst in einer ersten von vorn nach hinten verlaufenden Einführungsbewegung des Rechners zusammenwirken, bis die Achsen der einander zugeordneten Verbinderteile (18a, 18b, 118a, 218a, 118b, 218b) zusammenfallen, sodann bis zum Zusammenfügen der korrespondierenden Verbinderteile in einer zu dieser Einführungsbewegung orthogonalen zweiten Bewegung, und daß das an der Halterung angebrachte Verbinderteil (18b, 118b, 218b) von einer lösbar an der Seitenfläche (22) der Halterung befestigten Zusatzdose (38) getragen ist.

2. Halterung nach Anspruch 1, dadurch gekennzeichnet, daß die Zusatzdose eine Verteilerschaltung (25) aufweist, die die elektrische Verbindung des betreffenden Verbinderteils mit den von den einzelnen dem Rechner zugeordneten Ausrüstungsteilen des Turbostrahltriebwerks kommenden Kabelbündeln (24) ermöglichen, und daß die Buchsen des von der Zusatzdose getragenen Verbinderteils mit den Kontaktstiften des korrespondierenden Verbinderteils des Rechners über eine Öffnung (40) in der Seitenfläche der Halterung zusammenwirken.

3. Halterung nach einem der Ansprüche 1 und 2 für einen redundanten, gedoppelten Rechner, der aus zwei getrennten Rechnereinheiten (115, 215) besteht, die in zwei getrennten Kästen angeordnet sind, die jeweils wenigstens ein Verbinderteil (118a, 218a) aufweisen, dadurch gekennzeichnet, daß die beiden Kästen in der Halterung übereinander angeordnet sind und jeweils zweite Verhakungsmittel (20) tragen, die mit den ersten an der Halterung vorgesehenen Verhakungsmitteln (19) zusammenwirken, daß die Verbinderteile (118a, 218a) jeder Rechnereinheit mit den korrespondierenden Verbinderteilen (118b, 218b) zusammenwirken, und daß die Verteilerschaltung (25) der Zusatzdose die Verbindungen der beiden Rechnereinheiten (115, 215) untereinander und jeder Rechnereinheit mit den ihr zugeordneten Ausrüstungsteilen des Turbostrahltriebwerks ermöglicht.

4. Halterung nach einem der Ansprüche 2 oder 3, dadurch gekennzeichnet, daß die Verteilerschaltung aus einer gedruckten Schaltungsplatte (25) besteht, die einerseits das/die Verbinderteil(e) (18b, 118b, 218b) zur Verbindung mit dem/den Rechnereinheit(en) und anderseits die mit den von dem Turbostrahltriebwerk kommenden Kabelbündeln verbundenen Kontaktstifte trägt, wobei die Verteilerschaltung die elektrische Verbindung zwischen dem/den vielpoligen Verbinderteil(en) und den Kontaktstiften bewirkt.

5. Halterung nach einem der Ansprüche 1 bis 4, dadurch gekennzeichnet, daß die ersten Verhakungsmittel von Schlitzen (19) gebildet sind, die bajonettartig aus zwei miteinander verbunden orthogonalen Abschnitten gebildet sind, die in der Oberseite (7) und der Unterseite (8) der Halterung angebracht sind und mit den zweiten Verhakungsmitteln zusammenwirken, die aus an der Oberseite und an der Unterseite des Rechners angeordneten Stiften (20) bestehen.

6. Halterung nach einem der Ansprüche 1 bis 4, dadurch gekennzeichnet, daß die ersten Verhakungsmittel aus an der Rückseite (6) der Halterung ausgebildeten knopflochartigen Öffnungen (119) bestehen, die senkrecht zur Seitenfläche der Halterung orientiert sind und mit den zweiten Verhakungsmitteln zusammenwirken, die aus an der Rückseite des Rechners angeordneten Stiften (120) mit einem verbreiterten Kragen bestehen.

7. Halterung nach einem der Ansprüche 1 bis 4, dadurch gekennzeichnet, daß die ersten Verhakungsmittel aus einer an der Rückseite (6) der Halterung angeordneten Gleitschiene (219) mit wenigstens einer Aussparung (221) bestehen, die mit einer schwalbenschwanzförmigen Nut (220) zusammenwirkt, die wenigstens eine korrespondierende Einführungs-Aussparung (222) besitzt, die gegenüber der Aussparung der Gleitschiene so versetzt ist, daß der Rechner durch zwei aufeinanderfolgende Bewegungen in zueinander orthogonalen Richtung in seine Position gebracht werden kann.

8. Halterung nach einem der Ansprüche 1 bis 7, dadurch gekennzeichnet, daß sie an der Wand eines Turbostrahltriebwerks mittels Schwingungsdämpfungseinrichtungen (11) befestigt ist.

9. Halterung nach einem der Ansprüche 1 bis 8, dadurch gekennzeichnet, daß ihre Rückseite (6) von einem internen Kanal (12) durchsetzt ist, der mit einer Verteilerschaltung (14) für von einer Pumpe zugeführten unter Druck stehenden Kraftstoff verbunden ist, wobei die Umwälzung des Kraftstoffs innerhalb der Rückseite der Halterung über den Kontakt von Halterung und Rechner dessen Kühlung sicherstellt.

10. Halterung nach einem der Ansprüche 1 bis 8, dadurch gekennzeichnet, daß ihre Rückseite (6) von einem internen Kanal (12) durchsetzt ist, der mit einer Verteilerschaltung für von den ersten Verdichterstufen des Turbostrahltriebwerks abgeleitete Frischluft verbunden ist, wobei die Umwälzung der Luft innerhalb der Rückseite der Halterung über den Kontakt von Halterung und Rechner dessen Kühlung sicherstellt.

## Claims

1. Mounting for electronic computer, principally for aircraft turbojet engine, the computer comprising on one side face at least one multipin connector designed to come into contact with one matching connector fitted to the mounting, this latter comprising one rear face and/or an upper and lower face comprising a first means of latching (19, 119, 219) working in conjunction with a second means of latching (20, 120, 220) carried on the corresponding faces of the computer, characterised in that the mounting comprises, in addition, a side face carrying the connector of the mounting, and in that the mating of the connectors takes place perpendicularly to the said side face, in that the first and second means of latching are arranged so that they work by effecting an initial front to back movement to insert the computer in the mounting until the axes of the connectors are aligned (18a, 18b, 218a, 118b, 218b) then, in a second phase of movement in a direction perpendicular to the first, until the connectors are fully mated, and in that the connector (18b, 118b, 218b) linked to the mounting is carried by an associated connection box (38) fixed removably to the side face (22) of the mounting.

2. A mounting in accordance with Claim 1 characterised in that the associated connection box comprises a distribution circuit (25) ensuring the connection of the connector to the wiring harnesses (24) coming from the various items of equipment of the turbojet associated with the computer and in that the sockets of the female connector fixed to the associated box mate with the pins of the corresponding of the computer, through a cut-out (40) in the side face of the mounting.

3. A mounting in accordance with either of the Claims 1 and 2 for twin redundant computers, the computer being formed of two distinct computers (115, 215) housed in two separate cabinets each having at least one connector (118a, 218a) characterised in that the two cabinets are superimposed one on the other inside the mounting and each carries the second means of latching (20) working in conjunction with the first means of latching (19) carried on the mounting, in that the connectors (118a, 218a) of each computer mate with the corresponding mounting connectors (118b, 218b) and in that the distribution circuit (25) of the associated box ensures the link between the two computers and between each of them and the turbojet engine equipment with which they are associated.

4. A mounting in accordance with either of the Claims 2 or 3, characterised in that the distribution circuit is constituted by a printed circuit board (25) carrying on the one hand the connector(s) (18b, 118b, 218b) which ensure the connection to the computer(s) and, on the other hand, the connecting pins (26) connected to the wiring harnesses coming from the turbojet, the distribution circuit ensuring the electrical connection between the multipin connector(s) and the said connection pins.

5. A mounting in accordance with any of the Claims 1 to 4 characterised in that the first means of latching are constituted by two-part bayonet slots (19) each part at right angles to the other, cut in the upper and lower faces (7, 8) of the mounting and working in conjunction with the second means of latching constituted by pegs (20) fixed to the upper and lower faces of the computer.

6. A mounting in accordance with any one of the Claims 1 to 4 characterised in that the first means of latching are constituted by the openings (19) formed in the rear face (6) of the mounting and in the shape of keyholes placed perpendicularly to the side of the said mounting and working in conjunction with the second means of latching constituted by the pins (120) with enlarged heads carried on the rear face of the computer.

7. A mounting in accordance with any one of the Claims 1 to 4 characterised in that the first means of latching are constituted by a slid (219) fitted to the rear face (6) of the mounting and comprising at least one cut-out (221) working in conjunction with the the dovetailed groove (220) provided with at least one matching cut-out (222) offset from the first so as to allow the computer to be mounted in two successive movements at right angles to each other.

8. A mounting in accordance with any one of the Claims 1 to 7 characterised in that it is fixed to the casing of the turbojet engine by means of vibration damping devices (11).

9. A mounting in accordance with any of the Claims 1 to 8 characterised in that its rear face (6) is traversed by an internal duct (12) connected to a circuit (14) distributing fuel under pressure by means of a pump (13), the circulation of fuel within the rear face ensuring the cooling of the computer by virtue of the contact between the latter and the mounting.

10. A mounting in accordance with any one of the Claims 1 to 8 characterised in that its rear face (6) is traversed by an internal duct (12) connected to a circuit (14) distributing cold air bled from the first stages of the compressor of the turbojet engine, the circulation of air within the rear face of the mounting ensuring the cooling of the computer by virtue of the contact between the latter and the mounting.

F I G. 1

FIG. 2

FIG. 3

FIG. 4a

FIG. 4

FIG. 9

FIG. 5a

FIG. 5b

$d_2$

$d_1$

EP 0 213 019 B1

F I G. 6

FIG. 7

F I G. 8

EP 0 213 019 B1